# FASCICULE DE BREVET EUROPEEN

(11) **EP 3 224 701 B1**
(45) Date de publication et mention de la délivrance du brevet: **10.06.2020**
(21) Numéro de dépôt: 15821102.9
(22) Date de dépôt: 26.11.2015
(51) Int. Cl.: G06F 3/042, G06F 3/041, H03K 17/94, H03K 17/945, H03K 17/96, G06F 3/0488

(54) **DISPOSITIF ET PROCÉDÉ DE COMMANDE ET APPAREIL COMPORTANT UN TEL DISPOSITIF**
BETRIEBSVORRICHTUNG UND -VERFAHREN UND GERÄT MIT SOLCH EINER VORRICHTUNG
OPERATING DEVICE AND METHOD AND APPLIANCE COMPRISING SUCH A DEVICE

(30) Priorité: 26.11.2014 FR 1461530
(43) Date de publication de la demande: 04.10.2017
(73) Titulaire: Sequeris, 75116 Paris (FR); Falco, Jean-Louis, 30132 Caissarques (FR)
(72) Inventeur: FALCO, Jean-Louis, 30132 Caissargues (FR); PHILIPPE, Sébastien, 75116 Paris (FR)
(74) Mandataire: Cornuejols, Georges
(86) Numéro de dépôt international: PCT/FR2015/053231
(87) Numéro de publication internationale: WO 2016/083750

(56) Documents cités:
- EP-A1- 1 881 605
- EP-A1- 2 214 082
- EP-A1- 2 224 313
- EP-A1- 2 630 559
- EP-A2- 2 360 593
- EP-A2- 2 426 581
- WO-A1-02/35461
- WO-A1-2014/018119
- DE-A1-102010 026 910
- US-A1- 2006 244 733
- US-A1- 2011 175 832
- US-A1- 2014 184 541
- US-A1- 2014 213 323
- US-B1- 6 504 530

## Description

### DOMAINE DE L'INVENTION

La présente invention vise un dispositif et un procédé de commande et un appareil comportant un tel dispositif.

La présente invention s'applique au domaine des dispositifs de commande sans ou avec contact. Plus particulièrement, la présente invention s'applique au domaine de la commande d'appareils par un utilisateur.

### ÉTAT DE LA TECHNIQUE

On connaît les interfaces tactiles avec lesquelles un utilisateur touche un écran tactile pour commander des fonctions. Cependant, la sensibilité de ces écrans est variable et la succession d'appuis provoque une usure.

De plus, l'actionnement manuel des équipements mécaniques ou l'appui sur un écran tactile provoquent une trace disgracieuse et, à la longue, un encrassement.

Actuellement, les appareils comportent des boutons poussoirs ou des interrupteurs. Cependant, ces systèmes présentent l'inconvénient d'avoir un fonctionnement détérioré si des débris s'introduisent dans le mécanisme. Aussi, les équipements mécaniques et les écrans tactiles présentent des inconvénients en termes d'hygiène et de risque de contamination, surtout en cas d'usage collectif.

Il existe des appareils comportant des moyens de commande capacitifs. Mais, ces moyens de commande peuvent être déclenchés par des objets, tels un torchon par exemple. En revanche, les touches capacitives ne fonctionnent pas lorsque l'utilisateur porte un gant, sont soumises aux variations d'humidité dans l'air, et doivent être re-calibrées régulièrement. Ainsi, les moyens de commande capacitifs ne sont pas fiables.

L'art antérieur connaît la demande de brevet américain publiée sous le numéro US 2006/244733 A1 qui décrit un dispositif tactile mettant en application une détection pré-tactile afin d'augmenter la détermination de la localisation tactile. L'art antérieur connaît également le dispositif tactile objet de la demande de brevet américain publiée sous le numéro US 2011/175832 A1.

### OBJET DE L'INVENTION

La présente invention vise à remédier à tout ou partie de ces inconvénients.

À cet effet, selon un premier aspect, la présente invention vise un dispositif de commande selon la revendication 1.

Grâce à ces dispositions, lorsqu'un utilisateur veut commander une action, il met un objet (notamment un doigt) en regard des moyens de détection, d'une manière stable, donc avec une vitesse inférieure à la valeur prédéterminée, ce qui déclenche la commande d'une action. En revanche, lorsqu'un objet passe rapidement devant les moyens de détection, il ne déclenche aucune action du fait que sa vitesse est supérieure à la valeur prédéterminée.

Grâce à ces dispositions, la détermination de la position de l'objet est plus fiable.

Grâce à ces dispositions, la position fournie par les moyens de détection est moyennée, donc plus stable.

Dans des modes de réalisation, les moyens de détection sont configurés pour fournir une intensité de détection de l'objet en fonction de l'importance de l'interférence de l'objet avec chaque champ électromagnétique.

Dans des modes de réalisation, le moyen de commande est configuré pour commander une action si :
- les moyens de détection fournissent une position de l'objet,
- la vitesse de l'objet est inférieure à une valeur prédéterminée et
- l'intensité de détection est croissante ou supérieure à une valeur d'intensité prédéterminée.

Dans des modes de réalisation, la valeur d'intensité prédéterminée est fonction de l'intensité de détection maximale atteinte avant la décroissance de l'intensité de détection.

Grâce à chacune de ces dispositions, les fausses détections sont plus limitées.

Dans des modes de réalisation, les deuxièmes moyens de détection ne sont activés que si les premiers moyens de détection détectent la présence de l'objet.

Dans des modes de réalisation, la position fournie par les premiers moyens de détection est fonction d'une intensité de l'interférence de l'objet avec le champ électromagnétique détecté par les premiers moyens de détection et le poids affecté à la position fournie par les deuxièmes moyens de détection est fonction d'une intensité de l'interférence de l'objet avec le champ électromagnétique détecté par les deuxièmes moyens de détection.

Grâce à ces dispositions, une détection parasite de faible intensité par l'un des moyens de détection a peu d'influence sur la position prise en compte.

De plus, la mise en œuvre de la présente invention fournit un dispositif de commande présentant les avantages cumulés de deux moyens de commande tout en éliminant, ou au moins réduisant, leurs inconvénients.

Dans des modes de réalisation, les deuxièmes moyens de détection détectent la présence et la position de l'objet sans contact d'un utilisateur avec le dispositif.

La commande sans contact présente l'avantage de limiter l'encrassement et d'éviter un risque de contamination, par exemple.

Dans des modes de réalisation, les deuxièmes moyens de détection détectent la présence et la position de l'objet par contact d'un utilisateur avec le dispositif.

L'avantage de ces modes de réalisation est d'avoir une plus grande précision de la position de l'objet détectée.

Dans des modes de réalisation, les moyens de commande sont configurés pour commander une action si le moyen de détermination de vitesse détermine que les premiers moyens de détection détectent une vitesse supérieure à la valeur de vitesse prédéterminée et les deuxièmes moyens de détection détectent un appui de l'utilisateur sur le dispositif.

Grâce à ces dispositions, une action est commandée bien que la vitesse initiale de l'objet, déterminée avec les premiers moyens de détection, est supérieure à la valeur de vitesse prédéterminée, l'appui valant détermination d'une vitesse devenant inférieure à la valeur limite de vitesse prédéterminée.

Dans des modes de réalisation, l'onde émise par des moyens de détection est une onde infrarouge.

Ces modes de réalisation présentent l'avantage de permettre la détection d'un doigt d'un utilisateur, sans risquer de détecter un tissu, par exemple.

Dans des modes de réalisation, au moins un émetteur ou un récepteur des moyens de détection est associé à au moins un masque dont la partie transparente, pour au moins une longueur d'onde utilisée par l'émetteur, est allongée dans la direction d'un récepteur capable de détecter l'onde à ladite longueur d'onde.

Un tel masque présente l'avantage de réduire la réception d'ondes parasites.

Dans des modes réalisation, la présence de l'objet est détectée pour une puissance de l'onde reçue, par un récepteur des moyens de détection de présence, inférieure à une valeur limite prédéterminée.

L'avantage de ces modes de réalisation est d'éviter de prendre en considération la présence d'un objet, par exemple très réfléchissant, interagissant fortement avec les moyens de réception, tout en permettant de prendre en compte la présence d'un doigt d'un utilisateur en position d'effectuer une commande.

Dans des modes de réalisation, la présence de l'objet est détectée pour une puissance de l'onde électromagnétique reçue, par un récepteur des moyens de détection de présence, inférieure à une valeur limite prédéterminée.

L'avantage de ces modes de réalisation est d'éviter de détecter la présence d'un objet, capacitif ou en métal par exemple, tout en permettant de détecter la présence d'un doigt d'un utilisateur pour effectuer une commande. Ainsi, une casserole ou une poêle métallique, par exemple, qui, du fait de leur masse métallique, sature les récepteurs, n'est pas prise en considération.

Selon un deuxième aspect, la présence invention vise un procédé de commande qui comporte les étapes suivantes :
- détection fournissant une position d'un objet interférant avec un champ électromagnétique,
- détermination d'une vitesse de déplacement de l'objet, en fonction de la position de l'objet fournie par les moyens de détection et
- commande d'une action si :
   - la détection fournit une position de l'objet et
   - la vitesse de l'objet est inférieure à une valeur prédéterminée.

Les avantages, buts et caractéristiques particulières du procédé objet de la présente invention étant similaires à ceux du dispositif objet de la présente invention, ils ne sont pas rappelés ici.

Selon un troisième aspect, la présente invention vise un appareil réalisant une fonction, qui comporte au moins un dispositif de commande objet de la présente invention, commandant ladite fonction de l'appareil.

Les avantages, buts et caractéristiques particulières de l'appareil objet de la présente invention étant similaires à ceux du dispositif objet de la présente invention, ils ne sont pas rappelés ici.

### BREVE DESCRIPTION DES FIGURES

D'autres avantages, buts et caractéristiques particuliers de l'invention ressortiront de la description non limitative qui suit d'au moins un mode de réalisation particulier d'un dispositif, d'un procédé de commande et d'un appareil comportant un tel dispositif, en regard des dessins annexés, dans lesquels :
- la figure 1 représente, schématiquement, un mode de réalisation particulier d'un dispositif de commande objet de la présente invention,
- la figure 2 représente, schématiquement, un mode de réalisation particulier de premiers moyens de détection d'un dispositif objet de la présente invention,
- la figure 3 représente, schématiquement, un mode de réalisation particulier de deuxièmes moyens de détection d'un dispositif objet de la présente invention,
- la figure 4 représente, schématiquement, un mode de réalisation particulier d'un procédé objet de la présente invention,
- la figure 5 représente, schématiquement, un mode de réalisation particulier d'un appareil objet de la présente invention,
- la figure 6 représente une courbe d'évolution d'une vitesse en fonction du temps,
- la figure 7 représente une courbe d'évolution d'intensité de détection en fonction du temps,
- la figure 8 représente des positions détectées et moyennées,
- la figure 9 représente, sous forme d'un logigramme, un mode de réalisation particulier du procédé objet de la présente invention,
- la figure 10 représente, schématiquement et en coupe, un mode de réalisation particulier d'une partie d'un dispositif objet de la présente invention,
- les figures 11 et 12 représente, schématiquement et en vue de dessus, des exemples de dispositions géométriques de dispositifs le long ou de part et d'autre d'une ligne droite et
- la figure 13 représente, schématiquement et en coupe, un mode de réalisation particulier d'une partie d'un dispositif objet de la présente invention.

### DESCRIPTION D'EXEMPLES DE REALISATION DE L'INVENTION

On note, dès à présent, que les figures ne sont pas à l'échelle.

La présente description est donnée à titre non limitatif, chaque caractéristique d'un mode de réalisation pouvant être combinée à toute autre caractéristique de tout autre mode de réalisation de manière avantageuse.

On note que le terme « un » est utilisé au sens « au moins un ».

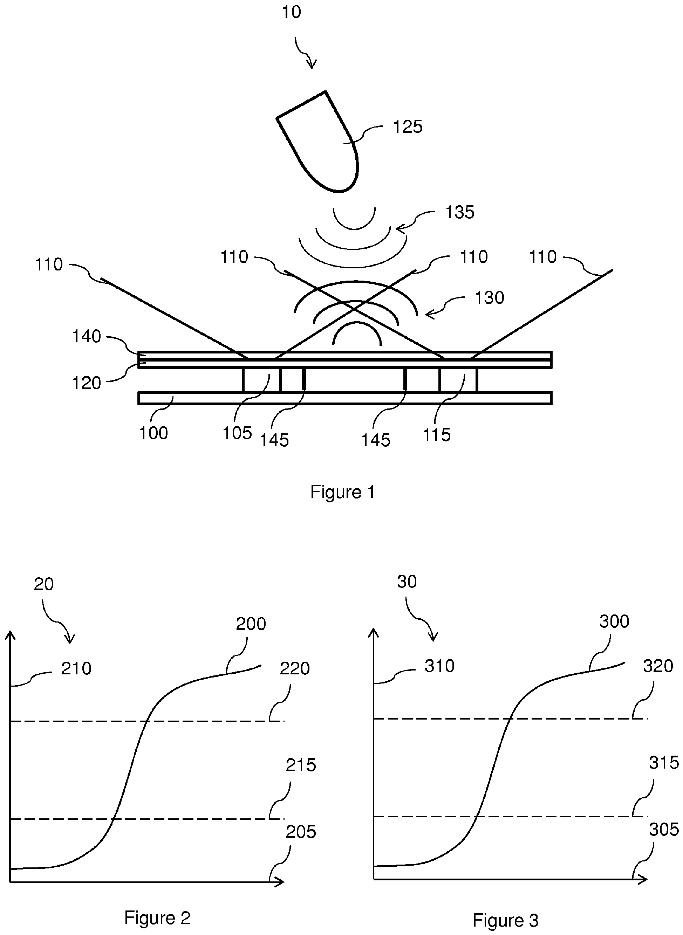

D'une manière générale, la présente invention met en oeuvre au moins un moyen de détection d'un objet interférant avec au moins un champ électromagnétique. L'objet considéré est, préférentiellement, un doigt. Ce champ électromagnétique peut être une onde optique, par exemple infrarouge, un champ électrique ou un champ magnétique. L'interférence peut consister, pour l'objet, à refléter ou à masquer le champ électromagnétique ou à influencer sa valeur mesurée par un détecteur. Chaque moyen de détection est configuré pour estimer une position relative de l'objet par rapport à une surface. Les figures 1 à 5 illustrent des modes de réalisation de l'invention mettant en oeuvre deux ensembles de moyens de détection. Cependant, la présente invention ne se limite pas à ce nombre et peut ne comporter qu'un seul ensemble de moyens de détection ou plus de deux ensembles de moyens de détection.

On observe sur la figure 1, un mode de réalisation particulier 10 d'un dispositif objet de la présente invention.

Le dispositif 10 de commande comporte des premiers moyens de détection, 105, 115 et 120, comportant au moins un émetteur, 105 d'au moins une onde 110 et au moins un récepteur 115 de l'au moins une onde 110 et détectant la présence et la position d'un objet 125 en fonction de l'au moins une onde 110 reçue.

Le dispositif 10 comporte aussi des deuxièmes moyens de détection, 140 et 145, détectant la présence et la position de l'objet 125 en fonction d'une grandeur physique 135.

Les deuxièmes moyens de détection, 140 et 145, ne sont activés que si les premiers moyens de détection, 105, 115 et 120, détectent la présence de l'objet 125.

La grandeur physique détectée par les deuxièmes moyens de détection, 140 et 145, est au moins une caractéristique différente de l'onde 110 reçue par le récepteur 115.

Le dispositif 10 comporte aussi des moyens de commande 100 configurés pour commander une action si :
- les premiers moyens de détection, 105, 115 et 120, détectent la présence de l'objet 125,
- les deuxièmes moyens de détection, 125, 140 et 145, détectent la présence de l'objet 125 et
- la position détectée par les premiers moyens de détection, 105, 115 et 120, correspond à la position détectée par les deuxièmes moyens de détection, 140 et 145.

Préférentiellement, les premiers moyens de détection, 105, 115 et 120, sont des moyens de détection dont chaque émetteur émet une onde 110 infrarouge, et dont chaque récepteur capte une onde infrarouge. Préférentiellement, les premiers moyens de détection, 105, 115 et 120, comportent une dalle 120, de répartition des ondes infrarouges 110.

L'onde 110 émise par l'émetteur 105 est répartie par la dalle 120. L'onde 110 se réfléchit sur un objet 125 qui réfléchit des ondes infrarouges et est captée par un récepteur 115. La présence de l'objet 125 est donc détectée par les premiers moyens de détection, 105, 115 et 120. Si l'objet 125 absorbe les ondes infrarouges, la présence de l'objet 125 n'est pas détectée par les premiers moyens de détection, 105, 115 et 120. La position de l'objet 125 est détectée en fonction de l'endroit sur la dalle infrarouge 120 où l'onde 110 est réfléchie, par exemple.

L'utilisation d'ondes infrarouges présente l'avantage de permettre la détection d'un doigt d'un utilisateur, sans risquer de détecter un tissu, par exemple.

Dans des modes de réalisation, l'émetteur 105 est entouré de symboles situés entre ledit émetteur et au moins un récepteur 115. La surface du dispositif 10 est opaque pour les longueurs d'ondes utilisées, sauf en regard du récepteur 115. En regard de l'émetteur 105, la surface du dispositif 10 est, au moins partiellement, transparente pour ces longueurs d'ondes, sur une zone allongée vers le récepteur. Ainsi, la puissance des ondes émises par l'émetteur 105 est plus importante dans la direction du récepteur 110 que dans les autres directions. La zone allongée définit ainsi un masque, dont la partie transparente, pour au moins une longueur d'onde utilisée par l'émetteur 105, est allongée dans la direction d'un récepteur 115 capable de détecter l'onde à ladite longueur d'onde. Ce masque dont la partie transparente, pour au moins une longueur d'onde utilisée par l'émetteur 105, est allongé dans la direction d'un récepteur 115 capable de détecter l'onde 110 à ladite longueur d'onde. Ce masque peut être rectangulaire ou elliptique, par exemple, la plus grande dimension du masque étant sensiblement parallèle à la droite reliant l'émetteur 105 et le récepteur 110. Dans des modes de réalisation, un tel masque est positionné en regard d'un récepteur 115, éventuellement en combinaison avec un tel masque positionné en regard d'un émetteur 105.

Préférentiellement, la grandeur physique 135 détectée par les deuxièmes moyens de détection, 140 et 145, est une grandeur physique d'une onde électromagnétique. Préférentiellement, les deuxièmes moyens de détection, 140 et 145, comportent un émetteur 140 d'une onde électromagnétique 130 et un récepteur 145 d'une onde électromagnétique 135.

Préférentiellement, les deuxièmes moyens de détection, 140 et 145, sont des moyens de détection dont un émetteur est une dalle 140 capacitive. La dalle capacitive est une surface parcourue par une grille accumulant une charge sur toute la surface de la dalle. L'onde 130 émise par la dalle 140 est déphasée par un objet 125 conducteur sans contact de l'objet 125 conducteur avec la dalle capacitive 140. L'onde 135 déphasée est captée par un récepteur capacitif 145. La présence d'un objet 125 est donc détectée. Si l'objet 125 n'est pas conducteur la présence de l'objet 125 n'est pas détectée par les deuxièmes moyens de détection, 140 et 145. Préférentiellement, l'onde 135 est une onde électromagnétique.

Dans des modes de réalisation, les deuxièmes moyens de détection, 140 et 145, sont des moyens de détection dont un émetteur est une dalle 140 capacitive. L'onde 130 émise par la dalle 140 est déphasée par un objet 125 conducteur en contact avec la dalle capacitive 140. L'onde 135 déphasé est captée par un récepteur capacitif 145. La présence d'un objet 125 est donc détectée. Si l'objet 125 n'est pas conducteur la présence de l'objet 125 n'est pas détectée par les deuxièmes moyens, 140 et 145, de détection.

La commande sans contact présente l'avantage de limiter l'encrassement et d'éviter un risque de contamination, par exemple.

Dans des modes de réalisation, les deuxièmes moyens de détection, 140 et 145, sont des moyens de détection comportant une dalle 140 résistive. La dalle 140 résistive est une surface parcourue par une grille accumulant une charge électrique sur toute la surface de la dalle. Lorsqu'un utilisateur appuie sur la dalle 140 résistive, un point de contact est créé et la présence d'un objet 125 est détectée.

L'avantage de la détection de présence et de position de l'objet par contact d'un utilisateur est d'avoir une plus grande précision de la position de l'objet détectée.

Dans des modes de réalisation, les premiers moyens de détection, 105, 115 et 120, et les deuxièmes moyens de détection, 140 et 145, sont :
- des moyens de détection par infrarouges,
- des moyens de détection capacitifs,
- des moyens de détection par radiofréquences,
- des moyens de détection par ondes radioélectriques,
- des moyens de détection résistifs,
- des moyens de détection thermiques,
- des moyens de détection mécaniques ou
- tout autre moyen de détection.

Bien que le mode de réalisation 10 de l'invention représenté dans les figures 1 à 5 soit un mode de réalisation dans lequel les premiers moyens de détection, 105, 115 et 120, sont des moyens de détection infrarouge et les deuxièmes moyens de détection, 140 et 145, sont des moyens de détection capacitifs. D'autres modes de réalisation dans lesquels les moyens de détection cités ci-dessus sont mis en œuvre font partie de l'objet de la présente invention.

La position de l'objet 125 détectée par les deuxièmes moyens de détection, 140 et 145, est déterminée en fonction de l'emplacement dans la dalle capacitive à laquelle le signal 130 émis est déformé.

Dans des modes de réalisation, les deuxièmes moyens de détection, 140 et 145, ne sont activés que si les premiers moyens de détection, 105, 115 et 120, détectent la présence de l'objet 125.

Dans des modes de réalisation, les premiers moyens de détection, 105, 115 et 120, ne sont activés que si les deuxièmes moyens de détection, 140 et 145, détectent la présence de l'objet 125.

Dans des modes de réalisation, les moyens de détection, 105, 115 et 120, sont les deuxièmes moyens de détection et les moyens de détection, 140 et 145, sont les premiers moyens de détection.

Les moyens de commande 100 sont configurés pour commander une action si :
- les premiers moyens de détection, 105, 115 et 120, détectent la présence de l'objet 125,
- les deuxièmes moyens de détection, 125, 140 et 145, détectent la présence de l'objet 125 et
- la position détectée par les premiers moyens de détection, 105, 115 et 120, correspond à la position détectée par les deuxièmes moyens de détection, 140 et 145.

L'action commandée est une action d'augmentation de la température, de diminution de la température ou de mise en fonctionnement d'un minuteur, par exemple. L'action commandée est en fonction de la position détectée.

On observe sur la figure 2, un premier mode de réalisation 20 de premiers moyens de détection, 105, 115 et 120, d'un dispositif 10 objet de la présente invention.

Le mode de réalisation 20 est illustré par un graphique montrant un signal 200 représentatif d'une onde 110 reçue par les premiers moyens de détection, 105, 115 et 120. Le signal 200 est représenté dans le graphique 20 comportant en abscisse 205, le temps, et en ordonnée 210, une puissance reçue.

Le mode de réalisation 20 comporte :
- une valeur limite prédéterminée de puissance 215, dite « valeur basse » et
- une valeur limite prédéterminée de puissance 220, dite « valeur haute ».

Si la puissance du signal 200 est inférieure à la valeur basse 215, les premiers moyens de détection, 105, 115 et 120, ne détectent pas l'objet 125. Si la puissance du signal 200 est supérieure à la valeur haute 220, les premiers moyens de détection, 105, 115 et 120, ne détectent pas l'objet 125. Si la puissance du signal 200 est inférieure à la valeur haute 220 et supérieure à la valeur basse 215, les premiers moyens de détection, 105, 115 et 120, détectent la présence d'un objet 125.

Grâce à la mise en œuvre de la valeur limite haute 220, on évite de détecter des objets, par exemple métalliques, qui auraient une interaction avec les premiers moyens de détection, 105, 115 et 120, très supérieure à l'interaction provoquée par le doigt d'un utilisateur.

On observe sur la figure 3, un premier mode de réalisation 30 de deuxièmes moyens de détection, 140 et 145, d'un dispositif 10 objet de la présente invention.

Le mode de réalisation 30 est illustré par un graphique montrant un signal 300 représentatif d'une onde 135 reçue par les deuxièmes moyens de détection, 140 et 145. Le signal 300 est représenté dans le graphique 30 comportant en abscisse 305, le temps, et en ordonnée 310, une puissance d'une grandeur physique.

Le mode de réalisation 30 comporte :
- une valeur limite prédéterminée de puissance 315, dite « valeur basse » et
- une valeur limite prédéterminée de puissance 320, dite « valeur haute ».

Si la puissance du signal 300 est inférieure à la valeur basse 315, les deuxièmes moyens de détection, 140 et 145, ne détectent pas l'objet 125. Si la puissance du signal 300 est supérieure à la valeur haute 320, les deuxièmes moyens de détection, 140 et 145, ne détectent pas l'objet 125. Si la puissance du signal 300 est inférieure à la valeur haute 320 et supérieure à la valeur basse 315, les deuxièmes moyens de détection, 140 et 145, détectent la présence d'un objet 125.

Grâce à la mise en œuvre de la valeur limite haute 320, on évite de détecter des objets, par exemple métalliques, qui auraient une interaction avec les deuxièmes moyens de détection, 140 et 145, très supérieure à l'interaction provoquée par le doigt d'un utilisateur.

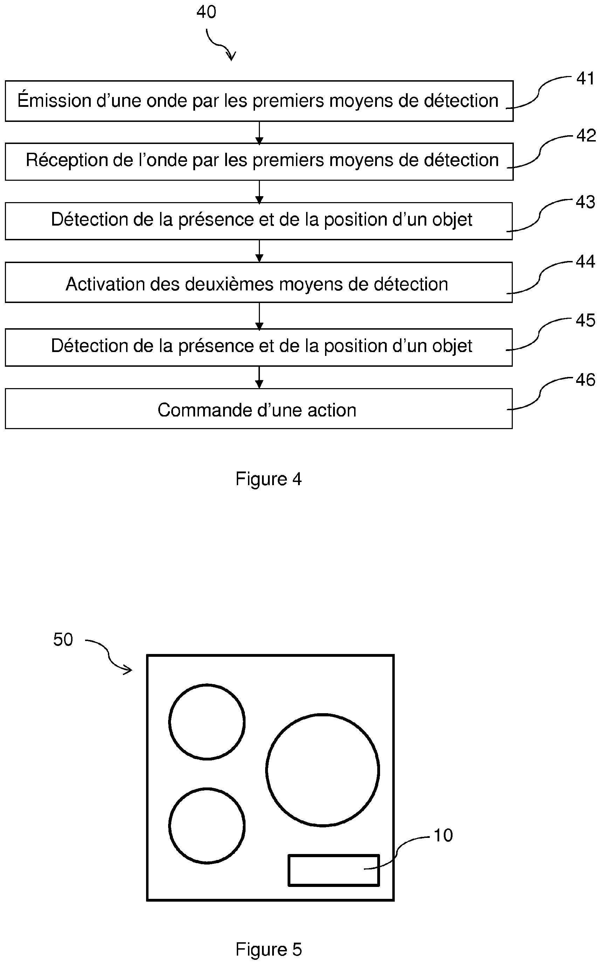

On observe sur la figure 4, un mode de réalisation particulier d'un procédé 40 objet de la présente invention.

Le procédé 40 de commande comporte les étapes suivantes :
- émission 41 d'au moins une onde 110, par un émetteur 105 de premiers moyens de détection, 105, 115 et 120,
- réception 42 de l'au moins une onde 110, par un récepteur 115 de premiers moyens de détection, 105, 115 et 120,
- détection 43 de la présence et de la position d'un objet 125 au moyen de l'au moins une onde 110 reçue,
- activation 44 de deuxièmes moyens de détection, 140 et 145,
- détection 45 de la présence et de la position d'un objet 125 en fonction d'une grandeur physique 135,
- commande 46 d'une action si la position détectée par les premiers moyens de détection, 105, 115 et 120, correspond à la position détectée par les deuxièmes moyens de détection, 140 et 145.

Préférentiellement, le procédé 40 de commande est mis en œuvre par un dispositif 10 de commande objet de la présente invention.

Au cours de l'étape d'émission 41, l'onde 110 émise par l'émetteur 105 est répartie par la dalle 120. L'onde 110 se réfléchit sur un objet 125 qui réfléchit des ondes infrarouges et est reçue par un récepteur 115, à l'étape 42 de réception. La détection de la présence de l'objet 125 est mise en œuvre par les premiers moyens de détection, 105, 115 et 120. Si l'objet 125 absorbe les ondes infrarouges, l'étape 43 de détection n'est pas effectuée. La détection 43 de la position de l'objet 125 est en fonction de l'endroit sur la dalle infrarouge 120 ou l'onde 110 est réfléchie, par exemple.

Une fois la présence de l'objet 125 détectée, le procédé 40 passe à l'étape 44 d'activation des deuxièmes moyens de détection, 140 et 145.

Préférentiellement, l'étape de détection 45 est en fonction d'une grandeur physique 135 et la grandeur physique 135 est une grandeur physique d'une onde électromagnétique.

Lors de l'étape de détection 45, la position de l'objet 125 détectée par les deuxièmes moyens de détection, 140 et 145, est déterminée en fonction de l'emplacement dans la dalle capacitive à laquelle le signal 130 émis est le plus modulé.

Dans des modes de réalisation, le procédé 40 comporte une étape de comparaison de la position détectée par les premiers moyens de détection à l'étape 43 et de la position détectée par les deuxièmes moyens de détection à l'étape 45. Si les positions détectées se correspondent, le procédé 40 passe à l'étape 46 de commande d'une action.

On a correspondance entre deux positions lorsque ces positions détectées ont sensiblement les mêmes coordonnées dans un même repère, en une ou deux dimensions, par exemple un repère orthogonal. Cette correspondance est donc déterminée avec une tolérance.

L'étape de commande 46 d'une action est mise en œuvre si :
- une présence de l'objet 125 est détectée à l'étape 43 de détection,
- une présence de l'objet 125 est détectée à l'étape 45 de détection et
- la position détectée à l'étape 43 de détection correspond à la position détectée à l'étape 45 de détection.

L'action commandée est une action d'augmentation de la température, de diminution de la température ou de mise en fonctionnement d'un minuteur, par exemple. L'action commandée est en fonction de la position détectée.

Comme on le comprend à la lumière de la description qui précède, la mise en œuvre de la présente invention permet ainsi une commande avec ou sans contact d'un appareil. De plus, comme deux ondes différentes sont utilisées pour détecter la présence et la position de l'objet, des erreurs de déclenchement de commandes sont évitées et le dispositif présente une plus grande fiabilité. Aussi, comme les deuxièmes moyens de détection ne sont activés que si les premiers moyens de détection détectent la présence de l'objet, une économie d'énergie est réalisée.

De plus, la mise en œuvre de la présente invention présente l'avantage de proposer un dispositif de commande présentant les avantages cumulés de deux moyens de commande tout en éliminant, ou au moins réduisant, leurs inconvénients.

On observe sur la figure 5, un mode de réalisation 50 d'un appareil objet de la présente invention.

L'appareil 50 présente au moins une fonction et comporte au moins un dispositif de commande objet de la présente invention, commandant au moins cette fonction.

Dans des modes de réalisation, l'appareil 50 est un appareil médical ou un ascenseur, par exemple. L'appareil 50 peut aussi être un appareil électroménager, par exemple qui comporte des plaques de cuisson ou un four dont le fonctionnement est commandé par un dispositif de commande objet de la présente invention.

Les commandes de l'appareil 50 sont effectuées par un utilisateur au moyen d'un dispositif 10 de commande. Les commandes sont préférentiellement effectuées sans contact de l'utilisateur avec l'appareil 50. Dans des modes de réalisation, les commandes sont effectuées avec contact de l'utilisateur avec l'appareil 50.

L'action commandée est une action d'augmentation de la température, de diminution de la température ou de mise en fonctionnement d'un minuteur, par exemple. L'action commandée est en fonction de la position détectée d'une partie du corps de l'utilisateur par rapport au dispositif 10 de commande.

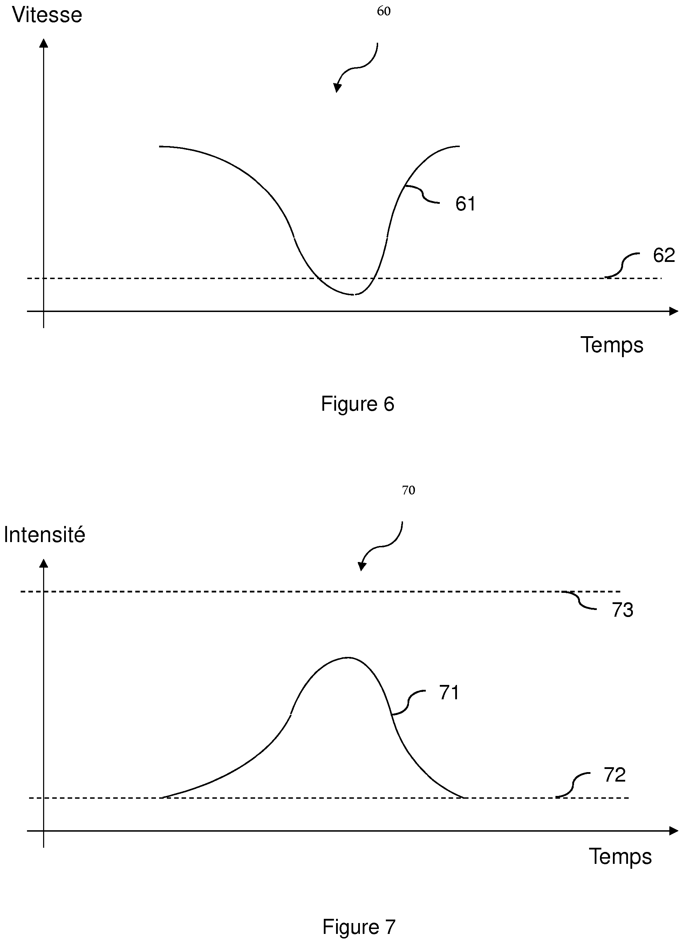

On observe, en figure 6, une courbe 60 d'évolution au cours du temps d'une vitesse 61 de déplacement de la position d'un objet détecté par au moins un moyen de détection de l'objet.

Comme exposé en regard des figures 1 à 5, les moyens de détection fournissent une estimation de la position de l'objet. La vitesse de l'objet est déterminée, selon au moins un axe, par différence de position entre deux instants.

Ainsi, les moyens de détection sont configurés pour fournir une position d'un objet interférant avec au moins un champ électromagnétique et un moyen de détermination de vitesse fournit une vitesse de déplacement de l'objet, en fonction de la position de l'objet fournie par les moyens de détection.

Dans des modes de réalisation préférentiels, on compare la vitesse ainsi déterminée avec une valeur limite prédéterminée 62. Par exemple, la valeur limite prédéterminée 62 vaut un centimètre par seconde.

Les moyens de commande sont configurés pour commander une action si :
- les moyens de détection fournissent une position de l'objet et
- la vitesse de l'objet est inférieure à une valeur de vitesse prédéterminée.

L'action commandée est celle qui est associée à la position de l'objet lorsque sa vitesse atteint la valeur limite prédéterminée ou lorsque la vitesse atteint sa valeur minimale et que cette valeur minimale est inférieure à la valeur limite prédéterminée.

La valeur limite prédéterminée peut être fixée par construction ou peut faire l'objet d'un réglage par l'utilisateur ou d'un apprentissage par le dispositif, par exemple pendant une phase d'installation pendant laquelle il est demandé à l'utilisateur de pointer son doigt vers chaque symbole représentant une action susceptible d'être commandée par le dispositif de commande objet de la présente invention.

La figure 7 représente une courbe 70 d'évolution de l'intensité de l'interférence entre l'objet et le champ électromagnétique détecté par les moyens de détection. La détection est effectuée lorsque cette intensité est comprise entre une valeur minimale d'intensité limite prédéterminée 72 et une valeur maximale d'intensité limite prédéterminée 73.

Par exemple, la valeur minimale d'intensité limite prédéterminée 72 vaut deux fois l'intensité du bruit ambiant mesuré. Par exemple, la valeur maximale d'intensité limite prédéterminée 73 vaut trois quarts de la valeur de saturation des moyens de détection. Selon un autre exemple, la valeur maximale d'intensité limite prédéterminée 73 est supérieure à l'intensité maximale constatée pendant une phase d'apprentissage avec un échantillon d'objets, par exemple de doigts, représentatif de la diversité humaine de morphologies et de couleurs de peau.

Ainsi, les moyens de détection sont configurés pour fournir une intensité de détection de l'objet en fonction de l'importance de l'interférence de l'objet avec le chaque champ électromagnétique.

Préférentiellement, le moyen de commande est configuré pour commander une action si :
- les moyens de détection fournissent une position de l'objet,
- la vitesse de l'objet est inférieure à une valeur prédéterminée et
- l'intensité de détection est croissante ou supérieure à une valeur d'intensité prédéterminée.

Préférentiellement, la valeur d'intensité prédéterminée est fonction de l'intensité de détection maximale atteinte avant la décroissance de l'intensité de détection. Par exemple, la valeur d'intensité prédéterminée est égale à la moitié ou les trois quarts de l'intensité maximale atteinte.

L'inventeur a déterminé que, cette valeur limite permet d'éviter des fausses détections.

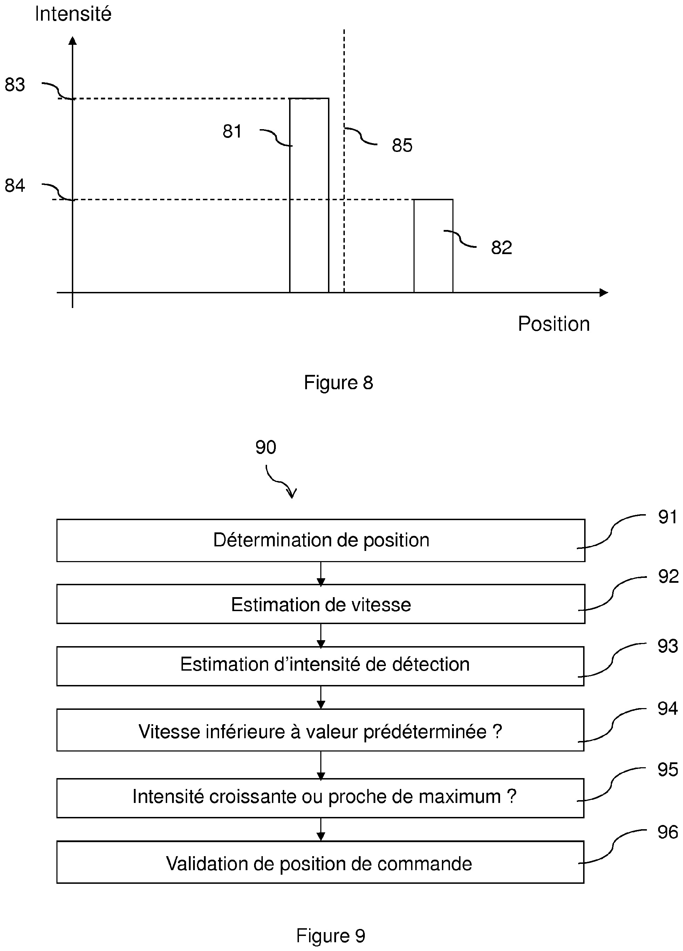

La figure 8 représente des positions 81 et 82 détectées par des premiers et des deuxièmes moyens de détection de l'objet, respectivement, ainsi que les intensités 83 et 84 de détection (c'est-à-dire d'interférence avec les champs électromagnétiques mis en œuvre par les différents ensembles de moyens de détection).

Dans des modes de réalisation, les moyens de détection fournissent une position 85 égale à une moyenne pondérée des positions fournies par les premiers moyens de détection et par les deuxièmes moyens de détection.

Préférentiellement, le poids affecté la position fournie par les premiers moyens de détection est fonction d'une intensité de l'interférence de l'objet avec le champ électromagnétique détecté par les premiers moyens de détection et le poids affecté à la position fournie par les deuxièmes moyens de détection est fonction d'une intensité de l'interférence de l'objet avec le champ électromagnétique détecté par les deuxièmes moyens de détection.

La position ainsi fournie est ainsi plus stable et plus fidèle à la position effective de l'objet.

On observe, en figure 9, des étapes 91 à 96 d'un procédé 90 de commande objet de la présente invention.

Ce procédé comporte les étapes suivantes :
- une étape 91 de détection fournissant une position d'un objet interférant avec un champ électromagnétique,
- une étape 92 de détermination d'une vitesse de déplacement de l'objet, en fonction de la position de l'objet fournie par les moyens de détection,
- une étape 93 d'estimation de l'intensité de détection,
- une étape 94 de détermination si la vitesse est inférieure à une valeur prédéterminée,
- une étape 95 de détermination si l'intensité de détection est croissante ou proche d'un maximum (c'est-à-dire que sa valeur est supérieure à une valeur fonction de l'intensité maximale, comme exposé ci-dessus) et
- si les étapes 94 et 95 fournissent des résultats positifs, une étape de commande d'une action associée à la position de l'objet.

Dans des variantes, les étapes 93 et 95 sont éliminées.

Dans des modes de réalisation, les moyens de commande sont configurés pour commander une action si le moyen de détermination de vitesse détermine que les premiers moyens de détection détectent une vitesse supérieure à la valeur de vitesse prédéterminée et les deuxièmes moyens de détection détectent un appui de l'utilisateur sur le dispositif.

Grâce à ces dispositions, une action est commandée bien que la vitesse initiale de l'objet, déterminée avec les premiers moyens de détection, soit supérieure à la valeur de vitesse prédéterminée, l'appui valant détermination d'une vitesse devenant inférieure à la valeur limite de vitesse prédéterminée.

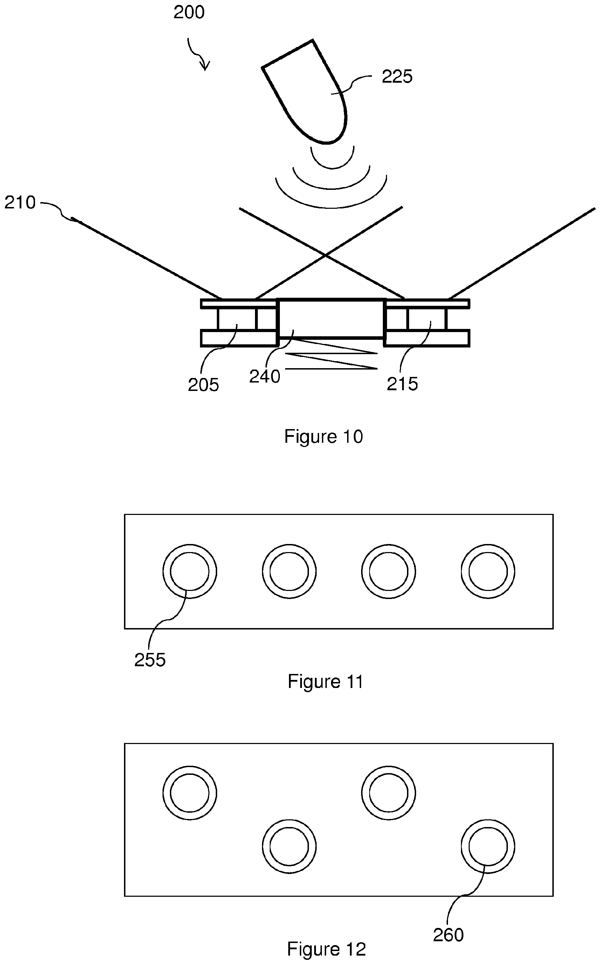

On observe sur la figure 10, un mode de réalisation particulier 200 d'un dispositif objet de la présente invention.

Le dispositif 200 de commande comporte des premiers moyens de détection, 205, 215, comportant au moins un émetteur, 205 de rayons infrarouges 210 et au moins un récepteur 215 des rayons infrarouges 210 réfléchis par l'objet 225. Les premiers moyens de détection sont constitués d'une dalle infrarouge. Préférentiellement, chaque émetteur 205 et chaque récepteur 215 est un émetteur-récepteur de rayons infrarouges.

Le dispositif 200 comporte aussi des deuxièmes moyens de détection, 240, détectant la présence et la position de l'objet 225 en fonction d'un appui de l'objet 225 sur les deuxièmes moyens de détection. Les deuxièmes moyens de détection sont constitués d'un bouton mécanique mobile, par exemple un bouton interrupteur.

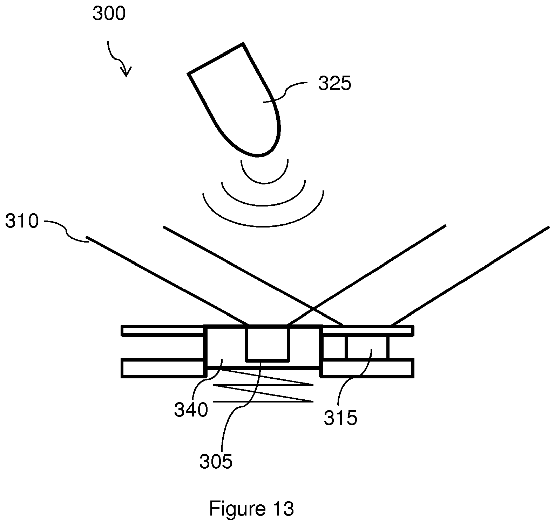

On observe sur la figure 13, un mode de réalisation particulier 300 d'un dispositif objet de la présente invention.

Le dispositif 300 de commande comporte des premiers moyens de détection, 305, 315, comportant au moins un émetteur, 305 de rayons infrarouges 310 et au moins un récepteur 315 des rayons infrarouges 310 réfléchis par l'objet 325. Les premiers moyens de détection sont constitués d'une dalle infrarouge. Préférentiellement, chaque émetteur 305 et chaque récepteur 315 est un émetteur-récepteur de rayons infrarouges.

Le dispositif 300 comporte aussi des deuxièmes moyens de détection, 340, détectant la présence et la position de l'objet 325 en fonction d'un appui de l'objet 325 sur les deuxièmes moyens de détection. Les deuxièmes moyens de détection sont constitués d'un bouton mécanique mobile, par exemple un bouton interrupteur.

Dans ce mode de réalisation, un émetteur 305 de rayons infrarouges se situe dans la partie mobile centrale du bouton mécanique mobile 340. En variante, un récepteur de rayons infrarouges se situe dans la partie mobile centrale du bouton mécanique mobile.

Les figures 11 et 12 illustrent des exemples de combinaisons de plusieurs dispositifs tels qu'illustrés en figure 10, permettant de créer un réseau maillé. Un des avantages de la mise en œuvre de la présente invention est la possibilité de relier les boutons entre eux afin d'en faire un réseau maillé intelligent. Si le système détecte que plusieurs dispositifs sont activés simultanément, il ne tient pas compte de la détection infrarouge et ne prend en compte que la détection mécanique.

On peut également (puisque le bouton mécanique est couplé au système infrarouge et à son « intelligence », repérer les dysfonctionnements mécaniques (usure des pièces)

La figure 11 illustre une disposition de dispositifs 255 le long d'une ligne droite.

La figure 12 illustre une disposition de dispositifs 255 alternativement de part et d'autre d'une ligne droite.

La position et la vitesse de l'objet évoquées en regard des figures, notamment figures 6 et 8, sont déterminées le long de cette ligne droite.

Dans tous les modes de réalisation, un indicateur, sonore ou visuel (voyant) peut être ajouté pour signaler que l'objet a été détecté et l'action validée. Dans les modes de réalisation comportant un bouton (voir, par exemple, figures 10 et 13), un voyant lumineux peut être placé au centre du bouton ou à l'extérieur du bouton.

## Revendications

1. Dispositif (10) de commande, **caractérisé en ce qu'**il comporte :
- des moyens de détection configurés pour fournir une position d'un objet interférant avec au moins un champ électromagnétique,
- un moyen de détermination d'une vitesse de déplacement de l'objet, en fonction de la position de l'objet fournie par les moyens de détection et
- des moyens de commande configurés pour commander une action si :
- les moyens de détection fournissent une position de l'objet et
- la vitesse de l'objet est inférieure à une valeur de vitesse prédéterminée ;
dans lequel les moyens de détection comportent :
- des premiers moyens de détection :
- comportant au moins un émetteur d'au moins une onde et au moins un récepteur de l'au moins une onde et
- détectant la présence et la position d'un objet en fonction de l'au moins une onde reçue et
- des deuxièmes moyens de détection :
- détectant la présence et la position de l'objet en fonction d'une grandeur physique ;
- la grandeur physique détectée par les deuxièmes moyens de détection ayant au moins une caractéristique différente de l'onde reçue par les premiers moyens de détection ;
les moyens de détection fournissant une position égale à une moyenne pondérée des positions fournies par les premiers moyens de détection et par les deuxièmes moyens de détection
et dans lequel si les premiers moyens de détection détectent plusieurs positions d'objet, les moyens de commande commandent une action uniquement si les deuxièmes moyens de détection fournissent une position d'un objet et uniquement en fonction de la position de l'objet fournie par les deuxièmes moyens de détection.

2. Dispositif selon la revendication 1, dans lequel les moyens de détection sont configurés pour fournir une intensité de détection de l'objet en fonction de l'importance de l'interférence de l'objet avec chaque champ électromagnétique, et dans lequel le moyen de commande est configuré pour commander une action si :
- les moyens de détection fournissent une position de l'objet,
- la vitesse de l'objet est inférieure à une valeur prédéterminée et
- l'intensité de détection est croissante ou supérieure à une valeur d'intensité prédéterminée.

3. Dispositif selon la revendication 2, dans lequel la valeur d'intensité prédéterminée est fonction de l'intensité de détection maximale atteinte avant la décroissance de l'intensité de détection.

4. Dispositif selon l'une des revendications 1 à 3, dans lequel les deuxièmes moyens de détection ne sont activés que si les premiers moyens de détection détectent la présence de l'objet.

5. Dispositif selon l'une des revendications 1 à 4, dans lequel la position fournie par les premiers moyens de détection est fonction d'une intensité de l'interférence de l'objet avec le champ électromagnétique détecté par les premiers moyens de détection et le poids affecté à la position fournie par les deuxièmes moyens de détection est fonction d'une intensité de l'interférence de l'objet avec le champ électromagnétique détecté par les deuxièmes moyens de détection.

6. Dispositif (10) selon l'une des revendications 1 à 5, dans lequel les deuxièmes moyens (140 et 145) de détection détectent la présence et la position de l'objet (125) sans contact d'un utilisateur avec le dispositif.

7. Dispositif (10) selon l'une des revendications 1 à 6, dans lequel les deuxièmes moyens (140 et 145) de détection détectent la présence et la position de l'objet (125) par contact d'un utilisateur avec le dispositif.

8. Dispositif selon la revendication 7, dans lequel les moyens de commande sont configurés pour commander une action si le moyen de détermination de vitesse détermine que les premiers moyens de détection détectent une vitesse supérieure à la valeur de vitesse prédéterminée et les deuxièmes moyens de détection détectent un appui de l'utilisateur sur le dispositif.

9. Dispositif selon l'une des revendications 1 à 8, dans lequel des moyens de détection comportent un émetteur et un récepteur d'ondes infrarouges et des moyens de détection comportent un bouton mécanique mobile.

10. Dispositif (10) selon l'une des revendications revendication 1 à 9, dans lequel un champ électromagnétique détecté par les moyens de détection prend la forme d'une onde infrarouge et dans lequel au moins un émetteur (105) ou un récepteur (115) des moyens (105, 115 et 120) de détection est associé à au moins un masque dont la partie transparente, pour au moins une longueur d'onde utilisée par l'émetteur, est allongée dans la direction d'un récepteur capable de détecter l'onde (110, 200) à ladite longueur d'onde.

11. Dispositif (10) selon la revendication 10, dans lequel la présence de l'objet est détectée pour une puissance (210) de l'onde (200) reçue, par un récepteur (115) des moyens (105, 115 et 120) de détection de présence, inférieure à une valeur limite prédéterminée (220).

12. Dispositif (10) selon l'une des revendications 1 à 11, dans lequel les moyens de détection sont configurés pour détecter la présence de l'objet (125) pour une intensité d'interférence de l'objet sur le champ électromagnétique inférieure à une valeur limite prédéterminée (320).

13. Procédé (40) de commande, **caractérisé en ce qu'**il comporte les étapes suivantes :
- détection fournissant une position d'un objet interférant avec un champ électromagnétique,
- détermination d'une vitesse de déplacement de l'objet, en fonction de la position de l'objet fournie par des premiers moyens de détection et
- commande d'une action si :
- la détection fournit une position de l'objet et
- la vitesse de l'objet est inférieure à une valeur prédéterminée ;
dans lequel l'étape de détection comporte :
- l'émission par des premiers moyens de détection d'au moins une onde et la réception de l'au moins une onde et la détectant de la présence et de la position d'un objet en fonction de l'au moins une onde reçue et
- la détection de la présence et de la position de l'objet par des deuxièmes moyens de détection, en fonction d'une grandeur physique, la grandeur physique détectée par les deuxièmes moyens de détection ayant au moins une caractéristique différente de l'onde reçue par les premiers moyens de détection ;
l'étape de détection fournissant une position égale à une moyenne pondérée des positions fournies par les premiers moyens de détection et par les deuxièmes moyens de détection et dans lequel si les premiers moyens de détection détectent plusieurs positions d'objet, une action est commandée uniquement si les deuxièmes moyens de détection fournissent une position d'un objet et uniquement en fonction de la position de l'objet fournie par les deuxièmes moyens de détection.

14. Appareil (50) réalisant une fonction, **caractérisé en ce qu'**il comporte au moins un dispositif (10) de commande selon l'une des revendications 1 à 12, commandant ladite fonction de l'appareil.

## Patentansprüche

1. Steuervorrichtung (10), **dadurch gekennzeichnet, dass** sie umfasst:
- Detektionsmittel, die ausgestaltet sind, um eine Position eines Gegenstandes zu liefern, der mit wenigstens einem elektromagnetischen Feld interferiert,
- ein Bestimmungsmittel einer Verschiebungsgeschwindigkeit des Gegenstandes in Abhängigkeit von der Position des Gegenstandes, die von den Detektionsmitteln geliefert wird, und
- Steuermittel, die zum Steuern einer Aktion ausgestaltet sind, wenn:
- die Detektionsmittel eine Position des Objekts liefern und
- die Geschwindigkeit des Objekts niedriger ist als ein vorbestimmter Geschwindigkeitswert;
bei dem die Detektionsmittel umfassen:
- erste Detektionsmittel:
- umfassend wenigstens einen Sender wenigstens einer Welle und wenigstens eines Empfängers der wenigstens einen Welle und
- Erfassen des Vorhandenseins und der Position eines Objekts in Abhängigkeit von der wenigstens einen empfangenen Welle und
- zweite Detektionsmittel:
- Erfassen des Vorhandenseins und der Position des Objekts in Abhängigkeit von einer physikalischen Größe;
- wobei die von den zweiten Detektionsmitteln erfasste physikalische Größe wenigstens ein Merkmal aufweist, das von der Welle unterschiedlich ist, die von den ersten Detektionsmitteln empfangen wird;
wobei die Detektionsmittel eine Position liefern, die gleich einem gewichteten Mittel der Positionen ist, die von den ersten Detektionsmitteln und von den zweiten Detektionsmitteln geliefert werden
und bei der, wenn die ersten Detektionsmittel mehrere Objektpositionen detektieren, die Steuermittel eine Aktion nur steuern, wenn die zweiten Detektionsmittel eine Position eines Objekts liefern und nur in Abhängigkeit von der Position des Objekts, die von den zweiten Detektionsmitteln geliefert wird.

2. Vorrichtung gemäß Anspruch 1, bei der die Detektionsmittel zum Liefern einer Detektionsintensität des Objekts in Abhängigkeit von dem Umfang der Interferenz des Objekts mit jedem elektromagnetischen Feld ausgestaltet sind und bei dem das Steuermittel zum Steuern einer Aktion ausgestaltet ist, wenn:
- die Detektionsmittel eine Position des Objekts liefern,
- die Geschwindigkeit des Objekts niedriger ist als ein vorbestimmter Wert und;
- die Intensität der Detektion ansteigt oder einen vorbestimmten Intensitätswert übersteigt.

3. Vorrichtung gemäß Anspruch 2, bei der der vorbestimmte Intensitätswert von der maximalen Detektionsintensität abhängt, die vor dem Abnehmen der Detektionsintensität erreicht wird.

4. Vorrichtung gemäß einem der Ansprüche 1 bis 3, bei der die zweiten Detektionsmittel nur aktiviert werden, wenn die ersten Detektionsmittel das Vorhandensein des Objekts detektieren.

5. Vorrichtung gemäß einem der Ansprüche 1 bis 4, bei der die von den ersten Detektionsmitteln gelieferte Position von einer Intensität der Interferenz des Objekts mit dem elektromagnetischen Feld abhängt, die von den ersten Detektionsmitteln detektiert wird, und das Gewicht, das der von den zweiten Detektionsmitteln gelieferten Position zugeordnet ist, von einer Intensität der Interferenz des Objekts mit dem elektromagnetischen Feld abhängt, das von den zweiten Detektionsmitteln detektiert wird.

6. Vorrichtung (10) gemäß einem der Ansprüche 1 bis 5, bei der die zweiten Detektionsmittel (140 und 145) das Vorhandensein und die Position des Objekts (125) ohne Kontakt eines Nutzers mit der Vorrichtung detektieren.

7. Vorrichtung (10) gemäß einem der Ansprüche 1 bis 6, bei der die zweiten Detektionsmittel (140 und 145) das Vorhandensein und die Position des Objekts (125) per Kontakt eines Nutzers mit der Vorrichtung detektieren.

8. Vorrichtung gemäß Anspruch 7, bei der die Steuermittel zum Steuern einer Aktion ausgestaltet sind, wenn das Bestimmungsmittel einer Geschwindigkeit bestimmt, dass die ersten Detektionsmittel eine größere Geschwindigkeit detektieren als den Wert der vorbestimmten Geschwindigkeit und die zweiten Detektionsmittel ein Aufdrücken des Nutzers auf der Vorrichtung detektieren.

9. Vorrichtung gemäß einem der Ansprüche 1 bis 8, bei der Detektionsmittel einen Sender und einen Empfänger von Infrarotwellen umfassen und Detektionsmittel eine mobile mechanische Taste umfassen.

10. Vorrichtung (10) gemäß einem der Ansprüche 1 bis 9, bei der ein elektromagnetisches Feld, das von den Detektionsmitteln erfasst wird, die Form einer Infrarotwelle annimmt und in der wenigstens ein Sender (105) oder ein Empfänger (115) der Detektionsmittel (105, 115 und 120) wenigstens einer Maske zugeordnet wird, deren transparenter Teil für wenigstens eine vom Sender verwendete Wellenlänge in der Richtung eines Empfängers verlängert ist, der in der Lage ist, die Welle (100, 200) in der genannten Wellenlänge zu detektieren.

11. Vorrichtung (10) gemäß Anspruch 10, bei der das Vorhandensein des Objekts für eine Leistung (210) der Welle (200) detektiert ist, die von einem Empfänger (115) der Detektionsmittel (105, 115 und 120) eines Vorhandenseins empfangen wird, die geringer ist als ein vorbestimmter Grenzwert (220).

12. Vorrichtung (10) gemäß einem der Ansprüche 1 bis 11, bei der die Detektionsmittel ausgestaltet sind, um das Vorhandensein des Objekts (125) für eine Interferenzintensität des Objekts auf dem elektromagnetischen Feld zu detektieren, die geringer ist als ein vorbestimmter Grenzwert (320).

13. Steuervorrichtung (40), **dadurch gekennzeichnet, dass** sie die folgenden Schritte umfasst:
- Detektionsmittel, die eine Position eines Objekts liefern, der mit wenigstens einem elektromagnetischen Feld interferiert,
- eine Bestimmung einer Verschiebungsgeschwindigkeit des Objekts in Abhängigkeit von der Position des Objekts, die von ersten Detektionsmitteln geliefert wird, und
- Steuern einer Aktion, wenn:
- die Detektion eine Position des Objekts liefert und
- die Geschwindigkeit des Objekts niedriger ist als ein vorbestimmter Wert;
bei dem der Detektionsschritt umfasst:
- das Senden wenigstens einer Welle und den Empfang der wenigstens einen Welle durch erste Detektionsmittel und bei deren Detektieren des Vorhandenseins und der Position eines Objekts in Abhängigkeit von der wenigstens einen empfangenen Welle und
- die Detektion des Vorhandenseins und der Position des Objekts durch zweite Detektionsmittel in Abhängigkeit von einer physikalischen Größe, wobei die von den zweiten Detektionsmitteln detektierte physikalische Größe wenigstens ein Merkmal aufweist, das von der Welle unterschiedlich ist, die von den ersten Detektionsmitteln empfangen wird;
wobei der Detektionsschritt eine Position liefert, die gleich einem gewichteten Mittel der Positionen ist, die von den ersten Detektionsmitteln und von den zweiten Detektionsmitteln geliefert werden
und bei der, wenn die ersten Detektionsmittel mehrere Objektpositionen detektieren, eine Aktion nur, wenn die zweiten Detektionsmittel eine Position eines Objekts liefern und nur in Abhängigkeit von der Position des Objekts, die von den zweiten Detektionsmitteln geliefert wird, gesteuert wird.

14. Gerät (50), das eine Funktion realisiert, **dadurch gekennzeichnet, dass** sie wenigstens eine Steuervorrichtung (10) gemäß einem der Ansprüche 1 bis 12 umfasst, die die genannte Funktion des Geräts steuert.

## Claims

1. Triggering device (10), **characterized in that** it comprises:
- detection means configured to supply a position of an object interfering with at least one electromagnetic field;
- a means for determining a speed of motion of the object according to the position of the object supplied by the detection means; and
- triggering means configured to trigger an action if:
- the detection means supply a position of the object; and
- the speed of the object is lower than a predefined speed value;
wherein the detection means comprise:
- first detection means:
- comprising at least one emitter of at least one wave and at least one receiver of at least one wave; and
- detecting the presence and position of an object as a function of the at least one wave received; and
- second detection means:
- detecting the presence and position of an object as a function of a physical magnitude;
- the physical magnitude detected by the second detection means differing by at least one characteristic from the wave received by the first detection means;
the detection means supplying a position equal to a weighted mean of the positions supplied by the first detection means and by the second detection means;
and wherein, if the first detection means detect several object positions, the triggering means trigger an action only if the second detection means supply a position of an object and only as a function of the position of the object supplied by the second detection means.

2. Device according to claim 1, wherein the detection means are configured to supply an intensity of detection of the object according to the magnitude of the object's interference with each electromagnetic field, and the triggering means is configured to trigger an action if:
- the detection means supply a position of the object;
- the speed of the object is lower than a predefined value; and
- the detection intensity is increasing or greater than a predefined intensity value.

3. Device according to claim 2, wherein the predefined intensity value is a function of the maximum detection intensity reached before the decrease in the detection intensity.

4. Device according to one of claims 1 to 3, wherein the second detection means are only activated if the first detection means detect the presence of the object.

5. Device according to one of claims 1 to 4, wherein the position supplied by the first detection means is a function of an intensity of the object's interference with the electromagnetic field detected by the first detection means, and the weight assigned to the position supplied by the second detection means is a function of an intensity of the object's interference with the electromagnetic field detected by the second detection means.

6. Device (10) according to one of claims 1 to 5, wherein the second detection means (140 and 145) detect the presence and position of the object (125) without a user being in contact with the device.

7. Device (10) according to one of claims 1 to 6, wherein the second detection means (140 and 145) detect the presence and position of the object (125) by a user's contact with the device.

8. Device according to claim 7, wherein the triggering means are configured to trigger an action if the speed determination means determine that the first detection means detect a speed greater than a predefined speed value, and the second detection means detect the user pressing on the device.

9. Device according to one of claims 1 to 8, wherein some detection means comprise an emitter and a receiver of infrared rays, and some detection means comprise a moving mechanical button.

10. Device (10) according to one of claims 1 to 9, wherein an electromagnetic field detected by the detection means takes the form of an infrared wave, and wherein at least one emitter (105) or receiver (115) of the detection means (105, 115 and 120) is associated with at least one mask, whose transparent portion, for at least one wavelength used by the emitter, is elongated in the direction of a receiver able to detect the wave (110, 200) at said wavelength.

11. Device (10) according to claim 10, wherein the presence of the object is detected for a power (210) of the wave (200) received, by a receiver (115) of the presence detection means (105, 115 and 120), below a predefined limit value (220).

12. Device (10) according to one of claims 1 to 11, wherein the detection means are configured to detect the presence of the object (125) for an intensity of the object's interference with the electromagnetic field below a predefined limit value (320).

13. Triggering method (40), **characterized in that** it comprises the following steps:
- detection supplying a position of an object interfering with an electromagnetic field;
- determination of a speed of motion of the object according to the position of the object supplied by first detection means; and
- triggering of an action if:
- the detection supplies a position of the object, and
- the speed of the object is lower than a predefined speed value;
wherein the detection step comprises:
- emission by first detection means of at least one wave and reception of the at least one wave, and detection of the presence and position of an object as a function of the at least one wave received; and
- detection of the presence and position of the object by second detection means, as a function of a physical magnitude, the physical magnitude detected by the second detection means differing by at least one characteristic from the wave received by the first detection means;
the detection step supplying a position equal to a weighted mean of the positions supplied by the first detection means and by the second detection means
and wherein, if the first detection means detect several object positions, an action is triggered only if the second detection means supply a position of an object and only as a function of the position of the object supplied by the second detection means.

14. Appliance (50) performing a function, **characterized in that** it comprises at least one triggering device (10) according to one of claims 1 to 12 triggering said function of the appliance.
